(19) Europäisches Patentamt
European Patent Office
Office européen des brevets

(11) Publication number: **0 620 500 A2**

# (12) EUROPEAN PATENT APPLICATION

(21) Application number: **94105635.0**

(22) Date of filing: **12.04.94**

(51) Int. Cl.$^5$: **G03F 7/004**, G03F 7/022, G03F 7/008

A request for correction of the description on page 6, line 14,"Curve 1"should be replaced by "Curve 2" and on page 6, line 16, "Curve 2" should be replaced by"curve 1" has been filed pursuant to Rule 88 EPC. A decision on the request will be taken during the proceedings before the Examination Division (Guidelines for Examination in the EPO, A-V, 2.2).

(30) Priority: **16.04.93 JP 89692/93**

(43) Date of publication of application:
**19.10.94 Bulletin 94/42**

(84) Designated Contracting States:
**DE FR GB IT**

(71) Applicant: **HITACHI, LTD.**
**6, Kanda Surugadai 4-chome**
**Chiyoda-ku, Tokyo 101 (JP)**
Applicant: **Hitachi Chemical Co., Ltd.**
**1-1, Nishishinjuku 2-chome**
**Shinjuku-ku, Tokyo 160 (JP)**

(72) Inventor: **Uchino, Shoichi**
**725-11, Naraharamachi**
**Hachioji-shi (JP)**
Inventor: **Migitaka, Sonoko**
**13-17, Higashimotomachi-3-chome**
**Kokubunji-shi (JP)**
Inventor: **Ueno, Takumi**
**32-10-505, Koyasumachi-3-chome**
**Hachioji-shi (JP)**
Inventor: **Onozuka, Toshihiko**
**657-5, Nogami**
**Ome-shi (JP)**
Inventor: **Shirai, Seiichirou**
**2-9-14-305, Ozakudai**
**Hamura-shi (JP)**
Inventor: **Moriuchi, Noboru**
**1-220-9, Imai**
**Ome-shi (JP)**
Inventor: **Sasaki, Mamoru**
**36-2, Suwacho-4-chome**
**Hitachi-shi (JP)**
Inventor: **Hashimoto, Michiaki**
**1611-57, Irumagawa**
**Sayama-shi (JP)**
Inventor: **Hayashi, Nobuaki**
**8-6, Musashidai-5-chome**
**Hidaka-shi (JP)**

(74) Representative: **Strehl Schübel-Hopf Groening & Partner**
**Maximilianstrasse 54**
**D-80538 München (DE)**

## (54) Resist and pattern formation using the same.

(57) Herein is disclosed a resist which comprises a water repellent compound having a functional group of which water repellent ability disappears through a nucleophilic substitution reaction with alkali or at least two functional groups, in one molecule, of which water repellent ability disappears through a reaction with alkali, and a permeability-variable composition of which alkaline solution-permeability is changed by radiation exposure or radiation exposure and baking after radiation exposure, said resist being excellent in sensitivity to UV light, electron beam, X-ray and other radiations, high in resolution capability and developable with aqueous alkaline solution; as well as a pattern forming method using said resist.

EP 0 620 500 A2

## BACKGROUND OF THE INVENTION

The present invention relates to resist materials sensitive to radiations such as laser light, UV light, far UV light, X-ray, electron beam and the like which can be used for the fine processing of semiconductor devices, optical discs, magnetic bubble devices, magnetic heads, liquid crystal devices and the like, and to a pattern forming method using said resist materials.

As prior art resist material for production of solid-state semiconductor devices, the positive resist mentioned in JP-A-4-174438 which is composed of a phenolic resin and diazonaphthoquinone, the negative resist mentioned in JP-A-59-222833 which is composed of a phenolic resin and azides, etc. are known. From said positive resist, a pattern is formed by irradiating it with UV light to convert the diazonaphthoquinone functioning as a dissolution inhibitor of the phenolic resin to an alkaline soluble indenecarboxylic acid, followed by dissolution of the UV-irradiated regions in an aqueous alkaline solution. On the other hand, from said negative resist, a pattern is formed by irradiating it to induce a crosslinking reaction between the azide and the phenolic resin and thereby to insolubilize the UV-irradiated regions, followed by dissolution of the non-irradiated regions in an aqueous alkaline solution.

As understandable from the above-mentioned two resists, conventional resists require that the material constituting a resist simultaneously has an excellent radiation sensitivity and an excellent solubility inhibition or promotion ability, and materials excellent only in radiation sensitivity or solubility inhibition or promotion ability are not usable for this purpose. Due to this restriction, it has been quite difficult to realize a resist having a high sensitivity and a high resolution simultaneously from conventional resist materials.

As a method for improving the characteristic properties of conventional resists, the method mentioned in JP-A-4-174438 can be referred to, for example. According to this method, the difference in dissolution rate between radiation-irradiated regions and non-irradiated regions is increased by adding alkali-soluble low molecular weight phenolic compounds to a positive photoresist and thereby enhancing the dissolution rate of radiation-irradiated regions. This method, however, has a problem in that addition of an alkali-soluble compound to a resist causes an increase in dissolution rate not only radiation-irradiated regions but also in non-irradiated regions and therefore the improvement in resolution is not great.

Further, as another type of resist, the chemically amplified resist disclosed in JP-A-59-45439 in which a high sensitivity is realized by giving separate substances the function of radiation sensitivity on the one hand and the function of solubility on the other hand can be referred to. The characteristic feature of chemically amplified resist consists in that a photoacid generator is used as a radiation-sensitive substance and the acid generated from the photoacid generator upon exposure to radiation is utilized as a catalyst for solubility promotion reaction or solubility inhibition reaction. Although the chemically amplified resist has high radiation-sensitivity characteristics, the resolution performance is not sufficient due to acid diffusion.

As a method for improving the resolution performance of chemically amplified resist, the method of utilizing the lactone ring opening reaction of phenolphthalein mentioned in SPIE Vol. 1672, Advances in Resist Technology and Processing IX (1992), pp. 194 can be referred to. Characteristic feature of this method consists in that the dissolution rate of radiation-exposed regions which have been made alkali-soluble by a deprotect reaction is additionally enhanced by the lactone ring opening reaction to aim at a high resolution. However, this method is disadvantageous in that a deprotection by radiation-exposure is necessary, the improvement of resolution performance is not great because the dissolution rate difference in aqueous alkaline solution is not great before and after the lactone ring opening reaction, and the method is not applicable to negative resists.

## SUMMARY OF THE INVENTION

Among the prior arts mentioned above, the conventional resists have been insufficient in sensitivity and resolution performance upon the pattern transfer by irradiation of radiations such as UV light, far UV light, X-ray, electron beam or the like. The chemically amplified resist has had a problem in that fine patterns of high resolution are difficult to form stably due to the acid diffusion. Further, the above-mentioned improving method of conventional resist and the method for improving resolution performance of chemically amplified resist have been unable to improve the resist properties to a great extent.

It is an object of this invention to provide a resist material on which fine patterns of high sensitivity and high resolution can be formed stably by a patternwise exposure to radiations such as UV light, far UV light, X-ray, electron beam, etc., and a pattern forming method using said resist material.

This invention provides a resist comprising a water repellent compound having a functional group of which water repellent ability disappears through a reaction with an alkali and a composition of which alkaline solution-permeability is changeable by radiation exposure or radiation exposure and baking after radiation

exposure (hereinafter said composition is referred to as "permeability-variable composition").

The present invention further provides a resist comprising a water repellent compound having at least two functional groups in one molecule of which water repellent ability disappears through reaction with an alkali and a permeability-variable composition of which alkaline solution-permeability is changeable by radiation exposure or radiation exposure and baking after radiation exposure.

BRIEF DESCRIPTION OF THE DRAWINGS

Fig. 1 is a graph illustrating the dissolution rates of radiation-nonirradiated region and radiation-irradiated region in the negative resist of this invention and a conventional negative resist;

Fig. 2 is a graph illustrating the sensitivity curves of the negative resist of this invention and a conventional negative resist; and

Fig. 3 is a graph illustrating the sensitivity curves of the positive resist of this invention and a conventional positive resist.

DESCRIPTION OF THE PREFERRED EMBODIMENTS

The resist material of this invention gives a positive resist when a permeability-variable composition of which alkaline solution-permeability increases upon radiation exposure is used, and gives a negative resist when a permeability-variable composition of which alkaline solution-permeability decreases upon radiation exposure is used.

In Fig. 2 and Fig. 3 are shown experimental results demonstrating that the resist of this invention is higher than conventional resist in sensitivity and resolution. In order to facilitate the comparison between the resist of this invention and conventional one, a resist containing a water repellent compound 1,3,5-tris-(bromoacetyl)-benzene is used therein as an example of the resist of this invention.

In Fig. 2, Curve I is sensitivity curve of a conventional negative resist comprising an azide and a phenolic resin. Curve II is sensitivity curve of a resist of this invention prepared by adding 1,3,5-tris-(bromoacetyl)-benzene to the resist of Curve I. It is apparent from the two curves that the resist of this invention is higher than the conventional one in sensitivity and resolution capability.

In Fig. 3, Curve III is sensitivity curve of a positive resist of this invention comprising 1,3,5-tris-(bromoacetyl)-benzene, diazonaphthoquinone and a phenolic resin, and Curve IV is sensitivity curve of a conventional positive resist comprising diazonaphthoquinone and a phenolic resin. It is apparent from Fig. 3 that the resist of this invention is higher than the conventional resist in sensitivity and resolution capability.

The reason why the resist of this invention has a high sensitivity and a high resolution capability can be considered as follows. Fig. 1 is a graph illustrating the dissolution rates of a negative resist of this invention and a conventional negative type resist in radiation-irradiated region and non-irradiated region; wherein A and B each express the dissolution rate of conventional resist in the radiation-nonirradiated region and irradiated region, respectively; C expresses difference between dissolution rates of radiation-nonirradiated region and irradiated region in conventional resist; A' and B' each express the dissolution rates of a resist of this invention in radiation-nonirradiated and irradiated regions, respectively; C' expresses difference between dissolution rates of radiation-nonirradiated region and irradiated region in the resist of this invention; D' expresses the virtual dissolution rate of radiation-nonirradiated region of the resist of this invention of which water repellent compound does not yet react with alkali (namely before alkali development); and E' expresses the dissolution rate of radiation-nonirradiated region in the resist of this invention of which dissolution rate has been enhanced by a reaction between the water repellent compound and alkali.

In the conventional negative type resist such as a mixture of a phenolic resin and an azide compound, a crosslinking reaction is caused between the radiation-sensitive component (azide) and the resin (phenolic resin) by exposure to radiation, due to which the dissolution rate decreases from A to B as shown in Fig. 1. A greater difference C between A and B more facilitates formation of high resolution pattern.

In conventional resists, the magnitude of C is generally proportional to the amount of radiation reaction, so that an enhancement of C can be achieved only by increasing the amount of radiation exposure. This results in that resolution enhancement and improvement in sensitivity are contradictory to each other.

On the other hand, in the resist of this invention prepared by adding a halogenated acetyl group-containing aromatic compound to a conventional resist of azide/phenolic resin type, the aromatic compound which is a water repellent compound functions as a dissolution inhibitor for the phenolic resin, due to which the dissolution rate of nonirradiated region shifts to D'. If the resist is developed with an aqueous alkaline solution in the next step, the aromatic compound in the non-irradiated region reacts with the alkali to lose the water repellent ability or change into a hydrophilic compound, due to which the dissolution rate of the

non-irradiated region increases from D' to A'. On the other hand, no reaction is induced between the aromatic compound and alkali in the irradiated region because alkali does not permeate thereinto, due to which the dissolution rate of irradiated region shifts to B' which is smaller than D' by C, provided that C is attributable to the insolubilization caused by crosslinkage formation between azide and phenolic resin. Accordingly, in the resist of this invention, the dissolution rate difference between irradiated region and nonirradiated region comes to C', wherein C' = C + E'.

As mentioned above, the negative resist of this invention is higher than conventional resist in the dissolution rate of non-irradiated region by E', which enables a further enhancement of sensitivity. In addition, the negative resist of this invention is greater than conventional resist in the dissolution rate difference, too, by E', which enables realization of a higher resolution capability. Positive resist of this invention also retains the same merit as above. These facts indicate that the resists of this invention are advantageous over conventional resists in the ability to form high resolution fine patterns.

As has been mentioned above, the characteristic feature of the resist of this invention consists in that, unlike conventional resists, the resist of this invention does not necessarily require to change the solubility of resist by radiation-exposure, but a radiation-exposure or a radiation-exposure followed by a baking can be utilized for changing the permeability of alkali solution into resist film, and this difference in permeability can be amplified and converted to a difference in solubility through a reaction between water-repellent compound and alkali.

Next, the function of the resist of this invention at the time of pattern formation will be explained. First, the case of positive resist will be mentioned by way of example. A positive resist of this invention is formed into a coating film on a substrate to be processed, and then irradiated with a radiation. If necessary, the coating film is baked after the irradiation. The baking is necessary in the case of, for example, chemically amplified resist. By the radiation-exposure, the permeability-variable composition is converted from a hydrophobic material to a hydrophilic material. Accordingly, if the resist film is developed with an aqueous alkaline solution, the aqueous alkaline solution selectively permeates into the region which has become showing a hydrophilic character due to the radiation-irradiation. The aqueous alkaline solution having permeated into the resist film reacts with the water repellent compound to eliminate the water repellent character of the water repellent compound. As its result, the irradiated regions of the resist are readily dissolved in the alkaline solution. On the other hand, the alkaline solution does not permeate into the nonirradiated regions, and therefore the water repellent compound present in the non-irradiated regions remains as it is without losing its water repellent character and acts as a strong dissolution inhibitor.

In the case of negative resist, the alkaline solution does not permeate into the irradiated regions, reversely to the above case. As the result, the water repellent compound remains as it is in the irradiated regions to act there as a strong dissolution inhibitor, while in the nonirradiated regions the alkaline solution converts the water repellent compound to a hydrophilic compound and therefore the irradiated regions are readily dissolved in the alkaline solution.

After extensive studies, the present inventors have found that compounds losing their water repellent character upon nucleophilic substitution reaction with an alkali or compounds having in one molecule two or more functional groups of which water repellent character disappears when the compound is reacted with alkali are effectively usable as said water repellent compound. Among these compounds, aromatic compounds which have two or more halogenated methyl or halogenated acetyl groups in a molecule, particularly on the same benzene ring among two or more benzene rings or fused benzene rings have been found to be the most effective compounds. The halogen atom of the halogenated methyl group or halogenated acetyl group is substituted with a hydroxyl group by a nucleophilic substitution reaction with alkali, due to which the aromatic compounds having these functional groups lose the water repellent character when reacted with alkali.

The aromatic compound having two or more halogenated acetyl groups in one molecule and thereby effectively usable in a resist can be represented by the formula:

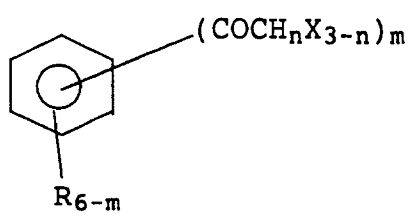

(I)

wherein n is zero or an integer of 1 or 2; X is chlorine or bromine; m is an integer of 2 to 4; and R is hydrogen, chlorine, bromine, a lower alkyl group preferably having 1 to 4 carbon atoms, more preferably 1 or 2 carbon atoms, or a lower alkoxy group preferably having 1 to 4 carbon atoms, more preferably 1 or 2 carbon atoms, or represented by the formula:

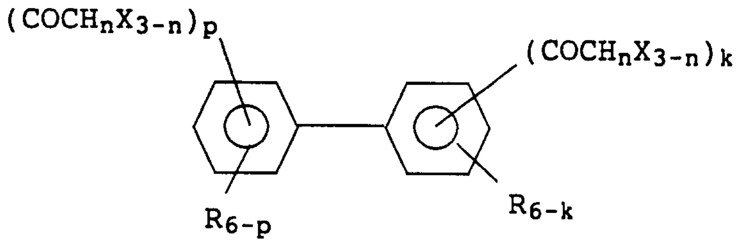

(II)

or

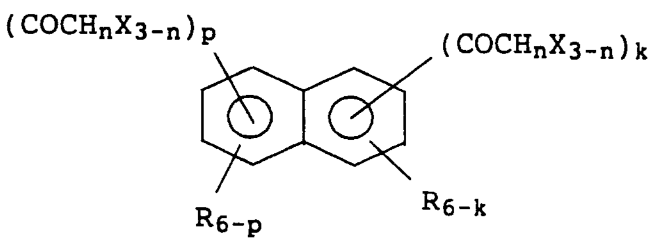

(III)

wherein R, X and n are as defined above; k is an integer of 3 or less, p is an integer of 3 or less, and k + p is an integer of 2 to 6.

Preferable examples of such compounds are as follows:
4,4'-bis(bromoacetyl)-biphenyl,
1,2-bis(bromoacetyl)-benzene,
1,3-bis(bromoacetyl)-benzene,
1,4-bis(bromoacetyl)-benzene,
1,2,3-tris(bromoacetyl)-benzene,
1,2,4-tris(bromoacetyl)-benzene,
1,3,5-tris(bromoacetyl)-benzene,
1,3,5-tris(dibromoacetyl)-benzene,
1,3,5-tris(tribromoacetyl)-benzene,
1,2,4,5-tetrakis(bromoacetyl)-benzene, etc.

These compounds can be produced by, for example, the process disclosed in S. Tajigaeshi, et al Bull. Chem. Soc. Japan, 60, 2667 (1987).

The aromatic compound having two or more halogenated methyl groups in one molecule and thereby effectively usable in a resist can be represented by the formula:

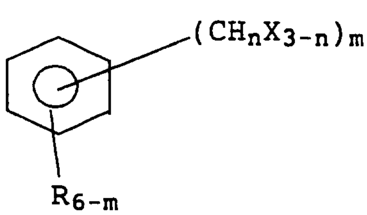

(IV)

wherein R, X, m and n are as defined above, or represented by the formula:

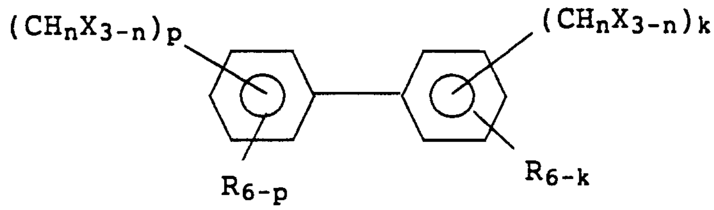

(V)

or

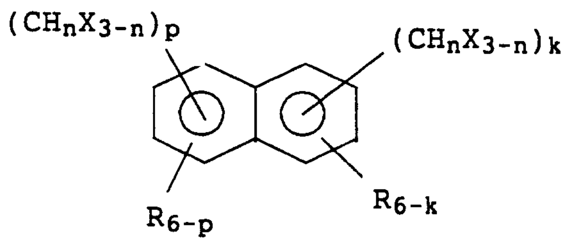

wherein R, X, n, k and p are as defined above.

Preferable examples of such compounds are as follows:

4,4'-bis(bromomethyl)-biphenyl,
1,2-bis(bromomethyl)-benzene,
1,3-bis(bromomethyl)-benzene,
1,4-bis(bromomethyl)-benzene,
1,2,3-tris(bromomethyl)-benzene,
1,2,4-tris(bromomethyl)-benzene,
1,3,5-tris(bromomethyl)-benzene,
1,3,5-tris(dibromomethyl)-benzene,
1,3,5-tris(tribromomethyl)-benzene,
1,2,4,5-tetrakis(bromomethyl)-benzene, etc.

Aromatic compounds to which chlorine atoms are combined in place of the bromine atoms are also usable for the same purpose as above. These aromatic compounds can function as a water repellent compound when used alone, and mixtures of two or more of these compounds are also usable. Among the aromatic compounds, those having three halogenated acetyl or halogenated methyl groups on the same benzene ring are very effective compounds because these compounds are drastically converted from water repellent compounds to hydrophilic compounds by reaction with alkalis. Apart from the aromatic compounds mentioned above, compounds having (1) halogenated sulfonyl group, (2) halogenated methyl sulfone group, (3) halogenated methyl sulfonic acid group and (4) halogenated methyl sulfoxide group are also usable.

Organic compounds having halogenated acetyl groups yield the corresponding halogenic acids when irradiated with a radiation in the presence of a hydrogen subtraction source. Accordingly, these compounds are advantageously usable in those resists which require a halogenic acid for the permeability-varying reaction.

In their nature, the aromatic compounds having a plurality of halogenated acetyl groups in molecule crosslink with phenolic resin when irradiated with UV light or when heated. Accordingly, heat resistance of resist can be enhanced by UV irradiation or baking after pattern formation, when the resist is required to have a high heat resistance.

It has been found that, as the permeability-variable composition used in this invention which increases its alkaline solution-permeability when irradiated with a radiation, a mixture of diazonaphthoquinone and phenolic resin, a mixture of poly(olefin sulfone) and phenolic resin, a mixture of a polymer prepared by protecting the phenolic hydroxyl groups of phenolic resin with tetrahydropyranyl group and a photoacid generator, and the like are effective. On the other hand, as the permeability-variable composition which decreases its alkaline solution-permeability when irradiated with a radiation, a mixture of aromatic azide and phenolic resin, a mixture of melamine resin, photoacid generator and phenolic resin, a mixture of carbinol compounds and photoacid generator and phenolic resin, a mixture of pinacol compound and photoacid generator and phenolic resin, and the like are effective.

In the chemically amplified resists among the above-mentioned resists, 1,3,5-tris(bromoacetyl)-benzene is used as a water repellent compound and a mixture of melamine resin, photoacid generator and phenolic resin is used as a permeability-variable composition. In this resist, 1,3,5-tris(bromoacetyl)-benzene functions as a water repellent compound and, at the same time, as a photoacid generator. If it is intended to increase the sensitivity of a chemically amplified resist further, acid generating efficiency of the photoacid generator must be enhanced. As a method thereof, the present inventors have thought out a method of additionally adding a photoacid generator of higher acid generating efficiency (hereinafter referred to as "high-efficiency photoacid generator"). In the case of electron beam irradiation, at least one member selected from the group consisting of 2-trichloromethyl-4(3H)-quinazoline, 1,3,5-tris(trichloromethyl)-triazine, 2-(4'-methoxybenzyl)-4,6-bis(trichloromethyl)-1,3,5-triazine, 2-(4'-methoxynaphthyl)-4,6-bis(trichloromethyl)-1,3,5-triazine, 2-(4'-methoxystyryl)-4,6-bis(trichloromethyl)-1,3,5-triazine, 2-(3',4',5'-trimethoxystyryl)-4,6-bis(trichloromethyl)-1,3,5-triazine, (4'-chlorostyryl)-4,6-bis(trichloromethyl)-1,3,5-triazine, α,α,α,-tribromoquinaldine and tribromomethylphenyl sulfone is added as the high-efficiency photoacid generator. In the case of i-line exposure, at least one member selected from the group consisting of 2-bromoacetylnaphthalene, 2-bromoacetyl-6,7-dimethoxynaphthalene, 1-hydroxy-4-bromo-2-bromoacetylnaphthalene, 1-hydroxy-4-bromo-2-dibromoacetylnaphthalene, 1,3,5-tris(bromoacetyl)-benzene, 3-bromoacetylcoumarine, 3-bromomethyl-7-methoxy-1,4-benzoxazin-2-one,4-bromomethyl-6,7-dimethoxycoumarine and 4-bromomethyl-7-methoxycoumarine is added as the high-efficiency photoacid generator.

The characteristic feature of this invention consists in a resist comprising a water repellent compound having a functional group of which water repellent ability disappears through a nucleophilic substitution reaction with alkali, or a compound having in one molecule at least two functional groups of which water repellent ability disappears through a reaction with alkali, and a permeability-variable composition varying its alkaline solution-permeability when irradiated with a radiation or when irradiated with a radiation and thereafter baked, as well as a pattern forming method using said resist, and this invention is not limited to combinations of the above-mentioned water repellent compounds of which water repellent ability disappears when reacted with alkali and the above-mentioned permeability-variable compositions varying their alkaline solution permeability when irradiated with a radiation.

Next, this invention is explained by referring to Examples. In the Examples, the kind of resist is referred to as "conventional type resist" or "chemically amplified resist" according to the description in "Background of the Invention".

Example 1

Herein is described a conventional negative type resist of Example 1 according to this invention.

A resist solution was prepared by dissolving, in cyclohexanone, 20 parts by weight of 1,3,5-tris-(bromoacetyl)-benzene as a water repellent compound together with a permeability-variable composition consisting of 100 parts by weight of m,p-cresol novolak resin and 10 parts by weight of 3,3'-dimethoxy-4,4'-bisazidobiphenyl to obtain a 20 wt.% solid content solution in cyclohexanone, followed by filtering the solution through a teflon membrane filter having a pore size of 0.2 µm. The resist solution was spin-coated on a silicon wafer and baked at 80 °C for 10 minutes to form a resist film having a thickness of 1.0 µm. After a patternwise exposure using i-line reduction projection aligner, development was carried out with 2.38 wt.% tetramethylammonium hydroxide aqueous solution for 250 seconds. Thus, a 0.35 µm lines/spaces fine pattern was formed at a dose of 200 $mJ/cm^2$.

Example 2

Herein is described a conventional negative type resist of Example 2 according to this invention.

A resist solution was prepared by dissolving, in cyclohexanone, 20 parts by weight of 1,3,5-tris-(bromoacetyl)-benzene as a water repellent compound together with a permeability-variable composition consisting of 100 parts by weight of m,p-cresol novolak resin and 10 parts by weight of 3-[4'-(p-azidophenyl)-1',3'-butadienyl]-5,5-dimethyl-2-cyclohexen-1-one to obtain a ca. 20 wt.% solid content solution in cyclohexanone, followed by filtering the solution through a teflon membrane filter having a pore size of 0.2 µm. The resist solution was spin-coated on a silicon wafer and baked at 80 °C for 5 minutes to form a resist film having a thickness of 0.5 µm. After a patternwise exposure using g-line reduction projection aligner, development was carried out with 2.7 wt.% tetramethylammonium hydroxide aqueous solution for 250 seconds. Thus, a 0.5 µm lines/spaces fine pattern was formed at a dose of 300 $mJ/cm^2$.

Example 3

A pattern was formed by repeating the procedure of Example 2, except that the exposure using g-line reduction projection aligner was replaced with a scanning exposure using argon laser beam. As a result, 0.5 µm lines/spaces fine pattern was formed at a dose of 400 $mJ/cm^2$.

Example 4

Herein is described a chemically amplified negative resist of Example 4 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin and 10 parts by weight of amino resin (Cymel 300: Mitsui Cyanamide Ltd.) to obtain a ca. 20 wt.% solid content solution in cyclohexanone, followed by filtering the solution through a teflon membrane filter having a pore size of 0.2 µm. Then, the resist solution was spin-coated on a silicon wafer and baked at 100 °C for 2 minutes to form a 1.0 µm-thick resist film. After exposure using i-line reduction projection aligner through a chromium mask, the resist film was heat-treated at 100 °C for 1.5 minute to promote the crosslinking reaction in the resist film. After a post exposure baking, the resist film was developed for 250 seconds in a 2.38 wt.% tetramethylammonium hydroxide aqueous solution. Thus, a 0.4 µm lines/spaces fine pattern was formed at a dose of 200 $mJ/cm^2$. In another run, the procedure mentioned above was repeated, except that 1,3,5-tris-(dibromoacetyl)-benzene was used in place of the 1,3,5-tris(bromoacetyl)-benzene. The results were similar to the above.

Example 5

A pattern was formed by repeating the procedure of Example 4, except that the chromium mask was replaced by a chromium mask with phase shift mask (Levenson type). As a result, a 0.3 µm lines/spaces fine pattern was formed at a dose of 250 $mJ/cm^2$.

Example 6

Herein is described a chemically amplified negative resist of Example 6 according to this invention.

A resist solution was prepared by dissolving, in cyclohexanone, 20 parts by weight of 1,3,5-tris-(bromoacetyl)-benzene as a water repellent compound together with 100 parts by weight of m,p-cresol novolak resin, 10 parts by weight of amino resin (Cymel 300: Mitsui Cyanamide Ltd.) and 1 part by weight of 2-(3',4',5'-trimethoxystyryl)-4,6-bis(trichloromethyl)-1,3,5-triazine to obtain a ca. 20 wt.% solid content solution in cyclohexanone, followed by filtering the solution through a teflon membrane filter having a pore size of 0.2 µm. In the resist solution, the 2-(3',4',5'-trimethoxystyryl)-4,6-bis(trichloromethyl)-1,3,5-triazine functioned as a photoacid generator. Then, the resist solution was spin-coated on a silicon wafer and baked at 100 °C for 2 minutes to form a 1.0 µm-thick resist film. The resist film was closely contacted with a chromium mask pattern and exposed to the light of Xe-Hg lamp through i-line (365 nm) interference filter. After the exposure, the resist film was heat-treated at 100 °C for 1.5 minute to promote the crosslinking reaction in the resist film. After the heat-treatment, the resist film was developed for 250 seconds in a 2.38 wt.% tetramethylammonium hydroxide aqueous solution. Thus, a 0.5 µm lines/spaces fine pattern was formed at a dose of 10 $mJ/cm^2$.

Example 7

Herein is described a chemically amplified negative resist of Example 7 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin and 10 parts by weight of amino resin (Cymel 300: Mitsui Cyanamide Ltd.) to obtain a ca. 20 wt.% solid content solution in cyclohexanone, followed by filtering the solution through a teflon membrane filter having a pore size of 0.2 µm. Then, the resist solution was spin-coated on a silicon wafer and baked at 100 °C for 2 minutes to form a 1.0 µm-thick resist film. The resist film was patternwise exposed to electron beam by means of an

electron beam writing system at an acceleration voltage of 50 KV. After the irradiation, the resist film was baked at 100 °C for 1.5 minute to promote the crosslinking reaction in the resist film. Then, the resist film was developed for 150 seconds in a 2.38 wt.% tetramethylammonium hydroxide aqueous solution. Thus, a 0.3 µm lines/spaces fine pattern was formed at a dose of 3 $\mu C/cm^2$.

Example 8

Herein is described a conventional type of positive resist of Example 8 according to this invention.

A resist solution was prepared by dissolving 0.08 g of a water repellent compound 1,3,5-tris-(bromoacetyl)-benzene in 2 g of positive type resist OFPR 800 (manufactured by Tokyo Ohka Kogyo Co., Ltd.), and then filtering the solution through a teflon membrane filter having a pore size of 0.2 µm. The resist solution was spin-coated on a silicon wafer and baked at 80 °C for 5 minutes to form a 1.0 µm-thick resist film. After exposure using g-line reduction projection aligner, the resist film was developed for 150 seconds with a 2.38 wt.% tetramethylammonium hydroxide aqueous solution. Thus, a 0.5 µm lines/spaces fine pattern was formed at a dose of 50 $mJ/cm^2$.

Example 9

Herein is described a conventional type of positive resist of Example 9 according to this invention.

A resist solution was prepared by dissolving, in isoamyl acetate, 20 parts by weight of a water repellent compound 1,3,5-tris(bromoacetyl)-benzene together with a permeability-variable composition consisting of 100 parts by weight of m,p-cresol novolak resin and 10 parts by weight of poly(2-methylpentene-1-sulfone) to obtain a ca. 20 wt.% solid content solution in isoamyl acetate and then filtering the solution through a teflon membrane filter having a pore size of 0.2 µm. The resist solution was spin-coated on a silicon wafer and baked at 80 °C for 10 minutes to form a 1.0 µm-thick resist film. After irradiating electron beam by means of an electron beam writing system at an accelerating voltage of 50 KV, the resist film was developed for 100 seconds with a 2.38 wt.% tetramethylammonium hydroxide aqueous solution. Thus, a 0.5 µm lines/spaces fine pattern was formed at a dose of 2 $\mu C/cm^2$.

Example 10

Herein is described a chemically amplified positive resist of Example 10 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin, 25 parts by weight of polyvinylphenol of which hydroxyl group had been protected with pyranyl group and 5 parts by weight of 1,2,3-tris(methanesulfonyloxy)-benzene to obtain a ca. 20 wt.% solid content solution in cyclohexanone, followed by filtering the solution through a teflon membrane filter having a pore size of 0.2 µm. Then, the resist solution was spin-coated on a silicon wafer and baked at 105 °C for 2 minutes to form a 1.0 µm-thick resist film. After irradiating the resist film with electron beam by means of an electron beam writing system at an accelerating voltage of 50 KV, the resist film was baked at 90 °C for 2 minutes and then developed for 100 seconds in a 2.38 wt.% tetramethylammonium hydroxide aqueous solution. Thus, a 0.3 µm lines/spaces fine pattern was formed at a dose of 3 $\mu C/cm^2$.

Example 11

Herein is described a chemically amplified negative resist of Example 11 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin, 10 parts by weight of meso-hydrobenzoin and 5 parts by weight of naphthoylmethyl tetramethylene-sulfonium triflate to obtain a ca. 20 wt.% solid content solution in cyclohexanone, followed by filtering the solution through a teflon membrane filter having a pore size of 0.2 µm. Then, the resist solution was spin-coated on a silicon wafer and baked at 100 °C for 2 minutes to form a 1.0 µm-thick resist film. After exposure through a chromium mask by means of i-line reduction projection aligner, the resist film was baked at 80 °C for 1.5 minutes to accelerate the reaction in the resist. Then the resist was developed for 60 seconds in a 2.38 wt.% tetramethylammonium

hydroxide aqueous solution. Thus, a 0.4 μm lines/spaces fine pattern was formed at a dose of 400 mJ/$cm^2$.

Example 12

Herein is described a chemically amplified negative resist of Example 12 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin, 10 parts by weight of α,α-dihydroxy-p-diisopropylbenzene and 5 parts by weight of naphthoylmethyl tetramethylenesulfonium triflate to obtain a ca. 20 wt.% solid content solution in cyclohexanone, followed by filtering the solution through a teflon membrane filter having a pore size of 0.2 μm. Then, the resist solution was spin-coated on a silicon wafer and baked at 90 °C for 2 minutes to form a 1.0 μm-thick resist film. After exposure through a chromium mask by means of i-line reduction projection aligner, the resist film was baked at 70 °C for 1.5 minutes to accelerate an insolubilization reaction in the resist. Then the resist was developed for 50 seconds in a 2.38 wt.% tetramethylammonium hydroxide aqueous solution. Thus, a 0.4 μm lines/spaces fine pattern was formed at a dose of 100 mJ/$cm^2$.

Example 13

Herein is described a chemically amplified negative resist of Example 13 according to this invention.

A resist solution was prepared by dissolving, in cyclohexanone, 20 parts by weight of 1,3,5-tris-(bromoacetyl)-benzene functioning as a water repellent compound and at the same time as a photoacid generator in the permeability-variable composition together with the residual part of the permeability-variable composition, namely 100 parts by weight of m,p-cresol novolak resin, 15 parts by weight of diphenyl carbinol and 5 parts by weight of naphthoylmethyl tetramethylenesulfonium triflate to obtain a ca. 20 wt.% solid content solution in cyclohexanone, followed by filtering the solution through a teflon membrane filter having a pore size of 0.2 μm. Then, the resist solution was spin-coated on a silicon wafer and baked at 100 °C for 2 minutes to form a 1.0 μm-thick resist film. After exposure through a chromium mask by means of i-line reduction projection aligner, the resist film was baked at 100 °C for 1.5 minutes to accelerate an insolubilization reaction in the resist. Then the resist was developed for 250 seconds in a 2.38 wt.% tetramethylammonium hydroxide aqueous solution. Thus, a 0.4 μm lines/spaces fine pattern was formed at a dose of 70 mJ/$cm^2$.

Example 14

Herein is described a conventional negative type resist of Example 14 according to this invention.

A resist solution was prepared by dissolving, in cyclohexanone, 20 parts by weight of 1,3,5-tris-(bromomethyl)-benzene as a water repellent compound together with a permeability-variable composition consisting of 100 parts by weight of m,p-cresol novolak resin and 10 parts by weight of 3,3'-dimethoxy-4,4'-bisazidobiphenyl to obtain a ca. 20 wt.% solid content solution in cyclohexanone, followed by filtering the solution through a teflon membrane filter having a pore size of 0.2 μm. The resist solution was spin-coated on a silicon wafer and baked at 80 °C for 10 minutes to form a resist film having a thickness of 1.0 μm. After exposure using i-line reduction projection aligner, development was carried out with 2.38 wt.% tetramethylammonium hydroxide aqueous solution for 500 seconds. Thus, a 0.4 μm lines/spaces fine pattern was formed at a dose of 200 mJ/$cm^2$.

Example 15

Herein is described a conventional negative type resist of Example 15 according to this invention.

A resist solution was prepared by dissolving, in cyclohexanone, 20 parts by weight of 1,3,5-tris-(bromomethyl)-benzene as a water repellent compound together with a permeability-variable composition consisting of 100 parts by weight of m,p-cresol novolak resin and 10 parts by weight of 3,3'-dimethoxy-4,4'-bisazidobiphenyl to obtain a ca. 10 wt.% solid content solution in cyclohexanone, followed by filtering the solution through a teflon membrane filter having a pore size of 0.2 μm. The resist solution was spin-coated on a silicon wafer and baked at 80 °C for 10 minutes to form a resist film having a thickness of 0.5 μm. After exposure using i-line reduction projection aligner in conjunction with a phase shift mask, the resist film was developed with 2.38 wt.% tetramethylammonium hydroxide aqueous solution for 200 seconds. Thus, a

0.25 µm lines/spaces fine pattern was formed at a dose of 200 $mJ/cm^2$.

Example 16

Herein is described a conventional negative type resist of Example 16 according to this invention.

A resist solution was prepared by dissolving, in cyclohexanone, 20 parts by weight of 1,4-di-(bromomethyl)-benzene as a water repellent compound together with a permeability-variable composition consisting of 100 parts by weight of poly(4-hydroxystyrene) and 20 parts by weight of 3,3'-dimethoxy-4,4'-bisazidobiphenyl to obtain a ca. 20 wt.% solid content solution in cyclohexanone, followed by filtering the solution through a teflon membrane filter having a pore size of 0.2 µm. The resist solution was spin-coated on a silicon wafer and baked at 80 °C for 10 minutes to form a resist film having a thickness of 1 µm. After exposure using i-line reduction projection aligner, the resist film was developed with 1.19 wt.% tetramethylammonium hydroxide aqueous solution for 200 seconds. Thus, a 0.4 µm lines/spaces fine pattern was formed at a dose of 200 $mJ/cm^2$.

Example 17

Herein is described a conventional negative type resist of Example 17 according to this invention.

A resist solution was prepared by dissolving, in cyclohexanone, 20 parts by weight of 1,3,5-tris-(bromomethyl)-benzene as a water repellent compound together with a permeability-variable composition consisting of 100 parts by weight of poly(4-hydroxystyrene) and 20 parts by weight of 3,3'-dimethoxy-4,4'-bisazidobiphenyl to obtain a ca. 20 wt.% solid content solution in cyclohexanone, followed by filtering the solution through a teflon membrane filter having a pore size of 0.2 µm. The resist solution was spin-coated on a silicon wafer and baked at 80 °C for 10 minutes to form a resist film having a thickness of 0.3 µm. After exposure using KrF excimer laser stepper, the resist film was developed with 1.19 wt.% tetramethylammonium hydroxide aqueous solution for 200 seconds. Thus, a 0.3 µm lines/spaces fine pattern was formed at a dose of 70 $mJ/cm^2$.

Example 18

Herein is described a conventional negative type resist of Example 18 according to this invention.

A resist solution was prepared by dissolving, in cyclohexanone, 20 parts by weight of 1,3,5-tris-(bromoacetyl)-benzene as a water repellent compound together with a permeability-variable composition consisting of 100 parts by weight of m,p-cresol novolak resin and 10 parts by weight of 3,3'-dimethoxy-4,4'-bisazidobiphenyl to obtain a ca. 20 wt.% solid content solution in cyclohexanone, followed by filtering the solution through a teflon membrane filter having a pore size of 0.2 µm. The resist solution was spin-coated on a silicon wafer and baked at 80 °C for 10 minutes to form a resist film having a thickness of 0.3 µm. After a patternwise exposure using i-line reduction projection aligner in conjunction with an edge sharpening type phase shift mask, the resist film was developed with 2.38 wt.% tetramethylammonium hydroxide aqueous solution for 200 seconds. Thus, a 0.1 µm of groove pattern was formed at a dose of 200 $mJ/cm^2$.

Example 19

Herein is described a conventional negative type resist of Example 19 according to this invention.

A resist solution was prepared by dissolving, in cyclohexanone, 20 parts by weight of 1,3,5-tris-(bromoacetyl)-benzene as a water repellent compound together with a permeability-variable composition consisting of 100 parts by weight of m,p-cresol novolak resin and 10 parts by weight of 3,3'-dimethoxy-4,4'-bisazidobiphenyl to obtain a ca. 20 wt.% solid content solution in cyclohexanone, followed by filtering the solution through a teflon membrane filter having a pore size of 0.2 µm. The resist solution was spin-coated on a silicon wafer and baked at 80 °C for 10 minutes to form a resist film having a thickness of 0.3 µm. After a patternwise exposure using i-line reduction projection aligner in conjunction with a Levenson type phase shift mask, the resist film was developed with 2.38 wt.% tetramethylammonium hydroxide aqueous solution for 200 seconds. Thus, a 0.25 µm lines/spaces fine pattern was formed at a dose of 200 $mJ/cm^2$.

In Examples 20-29 mentioned below, chemically amplified resists containing a high-efficiency photoacid generator are explained.

Example 20

In this example, a chemically amplified resist containing 2-trichloromethyl-4(3H)-quinazolinone as a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2-trichloromethyl-4(3H)-quinazolinone. The resist solution was spin-coated on a silicon wafer and baked at 100 ° C for 2 minutes to form a 1 μm-thick coating film. The film was irradiated with electron beam at an accelerating voltage of 50 KV, baked for 2 minutes, and developed for 100 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 1.5 $\mu C/cm^2$.

Example 21

In this example, a chemically amplified resist containing 2,4,6-trischloromethyl-1,3,5-triazine as a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2,4,6-tris(chloromethyl)-1,3,5-triazine. The resist solution was spin-coated on a silicon wafer and baked at 100 ° C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 1 $\mu C/cm^2$.

Example 22

In this example, a chemically amplified resist containing 2-(4'-methoxybenzyl)-4,6-bis(trichloromethyl)-1,3,5-triazineas a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2-(4'-methoxybenzyl)-4,6-bis(trichloromethyl)-1,3,5-triazine. The resist solution was spin-coated on a silicon wafer and baked at 100 ° C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 2 $\mu C/cm^2$.

Example 23

In this example, a chemically amplified resist containing 2-(4'-methoxynaphthyl)-4,6-bis(trichloromethyl)-1,3,5-triazine as a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2-(4'-methoxynaphthyl)-4,6-bis(trichloromethyl)-1,3,5-triazine. The resist solution was spin-coated on a silicon wafer and baked at 100 ° C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the

coating film of nonirradiated region was removed, and only the coating film which had been insolubilized by the irradiation remained on the wafer. As the result, a 0.3 μm lines/spaces fine pattern was formed at a dose of 2 $\mu C/cm^2$.

Example 24

In this example, a chemically amplified resist containing 2-(4'-methoxystyryl)-4,6-bis(trichloromethyl)-1,3,5-triazineas a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2-(4'-methoxystyryl)-4,6-bis(trichloromethyl)-1,3,5-triazine. The resist solution was spin-coated on a silicon wafer and baked at 100 °C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 2 $\mu C/cm^2$.

Example 25

In this example, a chemically amplified resist containing α,α,α-tribromoquinaldine as a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 5 parts by weight of α,α,α-tribromoquinaldine. The resist solution was spin-coated on a silicon wafer and baked at 100 °C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 3 $\mu C/cm^2$.

Example 26

In this example, a chemically amplified resist containing tribromomethylsulfone as a high-efficiency photoacid generator was irradiated with electron beam. Thus, a resist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 Parts by weight of tribromomethylphenylsulfone. The resist solution was spin-coated on a silicon wafer and baked at 100 °C for 2 minutes to form a 1 μm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 μm lines/spaces fine pattern was formed at a dose of 3 $\mu C/cm^2$.

Example 27

In this example, a chemically amplified resist containing 1,3,5-tris(trichloromethyl)-triazine and 2-trichloromethyl-4(3H)-quinazolinone as high-efficiency photoacid generators was irradiated with electron beam. Thus, a resist solution was prepared by dissolving, in cyclohexanone, 15 parts by weight of 1,3,5-tris-(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide), 10 parts by weight of 1,3,5-tris(trichloromethyl)-triazine and 7

parts by weight of 2-trichloromethyl-4(3H)-quinazolinone. The resist solution was spin-coated on a silicon wafer and baked at 100°C for 2 minutes to form a 1 µm-thick coating film. The film was irradiated with electron beam at an accelerating voltage of 50 KV, baked for 2 minutes, and developed for 200 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.3 µm lines/spaces fine pattern was formed at a dose of 1 $\mu C/cm^2$.

Example 28

In this example, a chemically amplified resist containing 2-bromoacetylcoumarine as a high-efficiency photoacid generator was irradiated with i-line. Thus, a photoresist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 10 parts by weight of 2-bromoacetylcoumarine. The resist solution was spin-coated on a silicon wafer and baked at 100°C for 2 minutes to form a 1.5 µm-thick coating film. The film was subjected to a fine pattern transfer by means of i-line reduction projection aligner and Levenson-type phase shift mask, baked for 2 minutes, and developed for 240 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.45 µm lines/spaces fine pattern was formed at a dose of 200 $mJ/cm^2$.

Example 29

In this example, a chemically amplified resist containing 4-bromo-1-hydroxy-2-bromoacetylnaphthalene as a high-efficiency photoacid generator was irradiated with i-line. Thus, a photoresist solution was prepared by dissolving, in cyclohexanone, 15 parts by weight of 1,3,5-tris(bromoacetyl)-benzene as a water repellent compound together with a permeability-variable composition consisting of 100 parts by weight of m,p-cresol novolak resin, 10 parts by weight of melamine resin (Cymel 300, manufactured by Mitsui Cyanamide) and 5 parts by weight of 4-bromo-1-hydroxy-2-bromoacetylnaphthalene. The resist solution was spin-coated on a silicon wafer and baked at 100°C for 2 minutes to form a 1.5 µm-thick coating film. The film was subjected to a fine pattern transfer by means of i-line reduction projection aligner and Levenson-type phase shift mask, baked for 2 minutes, and developed for 240 seconds with aqueous solution of tetramethylammonium hydroxide (trade name NMD-3, manufactured by Tokyo Ohka Kogyo Co., Ltd.). By this treatment, the coating film of nonirradiated region was removed, and only the coating film which had been insolubilized by the irradiation remained on the wafer. As the result, a 0.45 µm lines/spaces fine pattern was formed at a dose of 220 $mJ/cm^2$.

The resist material of this invention has excellent sensitivity and high resolution capability to radiations such as UV light, electron beam, X-ray and others. This invention has enabled a high-efficiency and low-cost formation of fine patterns necessary for production of semiconductor devices, optical discs, magnetic heads, magnetic bubble devices, etc.

## Claims

1. A resist comprising a water repellent compound having a functional group of which water repellent ability disappears through a nucleophilic substitution reaction with alkali and a permeability-variable composition of which alkaline solution-permeability is changed by radiation exposure or radiation exposure and baking after radiation exposure.

2. A resist comprising a water repellent compound having at least two functional groups in one molecule of which water repellent ability disappears through a nucleophilic substitution reaction with alkali and a permeability-variable composition of which alkaline solution-permeability is changed by radiation exposure or radiation exposure and baking after radiation exposure.

3. A resist according to Claim 1 or 2, wherein said water repellent compound has at least two halogenated acetyl groups or halogenated methyl groups in one molecule.

4. A resist according to Claim 3, wherein said water repellent compound is an aromatic compound.

5. A resist according to Claim 4, wherein at least one of the benzene rings constituting said aromatic compound has at least two halogenated acetyl groups or halogenated methyl groups.

6. A resist according to Claim 5, wherein said aromatic compound is represented by the following formula:

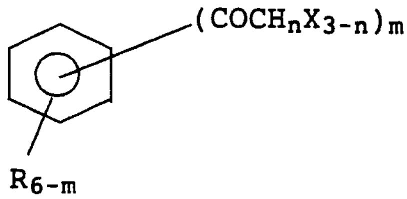

wherein n is zero or an integer of 1 or 2; X is chlorine or bromine; m is an integer of 2 to 4; and R is hydrogen, chlorine, bromine, a lower alkyl group or a lower alkoxy group, and a plurality of R's may be the same or different.

7. A resist according to Claim 6, wherein said aromatic compound is 1,2-bis(bromoacetyl)-benzene, 1,3-bis(bromoacetyl)-benzene, 1,4-bis(bromoacetyl)-benzene, 1,3,5-tris(bromoacetyl)-benzene, 1,2,3-tris-(bromoacetyl)-benzene, 1,2,4-tris(bromoacetyl)-benzene, 1,3,5-tris(dibromoacetyl)-benzene, or 1,2,4,5-tetrakis(bromoacetyl)-benzene.

8. A resist according to Claim 5, wherein said aromatic compound is represented by the formula:

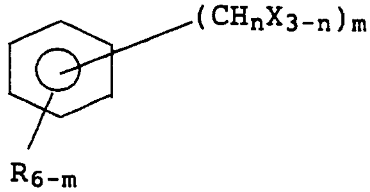

wherein n is zero or an integer of 1 or 2; X is chlorine or bromine; m is an integer of 2 to 4; and R is hydrogen, chlorine, bromine, a lower alkyl group or a lower alkoxy group, and a plurality of R's may be the same or different.

9. A resist according to Claim 8, wherein said aroamtic compound is 1,2-bis(bromomethyl)-benzene, 1,3-bis(bromomethyl)-benzene, 1,4-bis(bromomethyl)-benzene, 1,2,3-tris(bromomethyl)-benzene, 1,2,4-tris-(bromomethyl)-benzene, 1,3,5-tris(bromomethyl)benzene, 1,3,5-tris(dibromomethyl)-benzene, or 1,2,4,5-tetrakis(bromomethyl)-benzene.

10. A resist according to Claim 1 or 2, wherein said permeability-variable composition has a nature of increasing its alkaline solution-permeability when subjected to radiation exposure or to radiation exposure and baking after radiation exposure.

11. A resist according to Claim 10, wherein said permeability-variable composition comprises at least one phenolic resin and diazonaphthoquinone.

12. A resist according to Claim 10, wherein said permeability-variable composition comprises at least one phenolic resin and poly(olefin)sulfone.

13. A resist according to Claim 9, wherein said permeability-variable composition comprises at least one phenol compound protected with a protecting group which can readily be eliminated by a reaction with acid, and a photoacid generator.

**14.** A resist according to Claim 1 or 2, wherein said permeability-variable composition has a nature of decreasing its alkaline solution-permeability when subjected to radiation exposure or radiation exposure and baking after radiation exposure.

**15.** A resist according to Claim 14, wherein said permeability-variable composition comprises at least one phenolic resin and an amino resin.

**16.** A resist according to Claim 14, wherein said permeability-variable composition comprises at least one phenolic resin, an amino resin and a high-efficiency photoacid generator.

**17.** A resist according to Claim 16, wherein said high-efficiency photoacid generator has at least one trihalogenomethyl group.

**18.** A resist according to Claim 17, wherein said high-efficiency photoacid generator is at least one member selected from the group consisting of 1,3,5-tris(trichloromethyl)-triazine, 2-(4'-methoxybenzyl)-4,6-bis-(trichloromethyl)-1,3,5-triazine, 2-(4'-methoxynaphthy1)-4,6-bis(trichloromethyl)-1,3,5-triazine, 2-(4'-methoxystyryl)-4,6-bis(trichloromethyl)-1,3,5-triazine, 2-(3',4',5'-trimethoxystyryl)-4,6-bis(trichloromethyl)-1,3,5-triazine, 4'-chlorostyryl-4,6-bis(trichloromethyl)-1,3,5-triazine and 2-trichloromethyl-4(3H)-quinazolinone.

**19.** A resist according to Claim 16, wherein said high-efficiency photoacid generator is at least one member selected from the group consisting of 2-bromoacetyl-6,7-dimethoxynaphthalene, 3-bromoacetylcoumarine, 3-bromomethyl-7-methoxy-1,4-benzoxazin-2-one and 4-bromomethyl-6,7-dimethoxycoumarine.

**20.** A resist according to Claim 14, wherein said permeability-variable composition comprises at least one phenolic resin and an aromatic azide compound.

**21.** A resist according to Claim 14, wherein said permeability-variable composition comprises at least one phenolic resin, a compound which can be dehydrated when reacted with acid, and a photoacid generator.

**22.** A pattern forming method which comprises a step for forming, on a substrate, a coating film of a resist comprising a permeability-variable composition of which alkaline solution-permeability is changed by radiation exposure according to one of Claims 1 to 21, a step for exposing a prescribed part of said coating film to a radiation, and a step for developing said coating film by using an alkaline solution as a developer to obtain an intended pattern of the coating film.

**23.** A pattern forming method which comprises a step for forming, on a substrate, a coating film of a resist comprising a permeability-variable composition of which alkaline solution-permeability is changed by radiation exposure and baking after the radiation exposure according to one of Claims 1 to 21, a step for exposing a prescribed part of said coating film to a radiation, a step for baking the coating film after the step of exposure and a step for developing said coating film by using an alkaline solution as a developer to obtain an intended pattern of the coating film.

**24.** A pattern forming method according to Claim 22 or 23, wherein said radiation exposure is carried out through intermediation of a phase shift mask.

**25.** A pattern forming method according to Claim 23, wherein said radiation is electron beam.

**26.** A pattern forming method according to one of Claims 22 to 25 which comprises an additional step for irradiating a light having a wavelength of 365 nm or shorter to the coating film pattern.

**27.** A pattern forming method according to one of Claims 22 to 26 which comprises an additional step for heating said coating film pattern.

**28.** An aromatic compound represented by the following general formula:

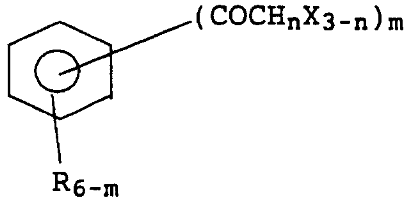

wherein n is zero or an integer of 1 or 2; X is chlorine or bromine; m is an integer of 2 to 4; and R is hydrogen, chlorine, bromine, a lower alkyl group or a lower alkoxy group, and a plurality of R's may be the same or different.

**29.** An aromatic compound according to Claim 28, wherein said aromatic compound is 1,3,5-tris-(bromoacetyl)-benzene, 1,3,5-tris(dibromoacetyl)-benzene, or 1,2,4,5-tetrakis(bromoacetyl)-benzene.

**30.** An aromatic compound according to Claim 28 or 29, wherein said aromatic compound functions as a photoacid generator.

FIG. I

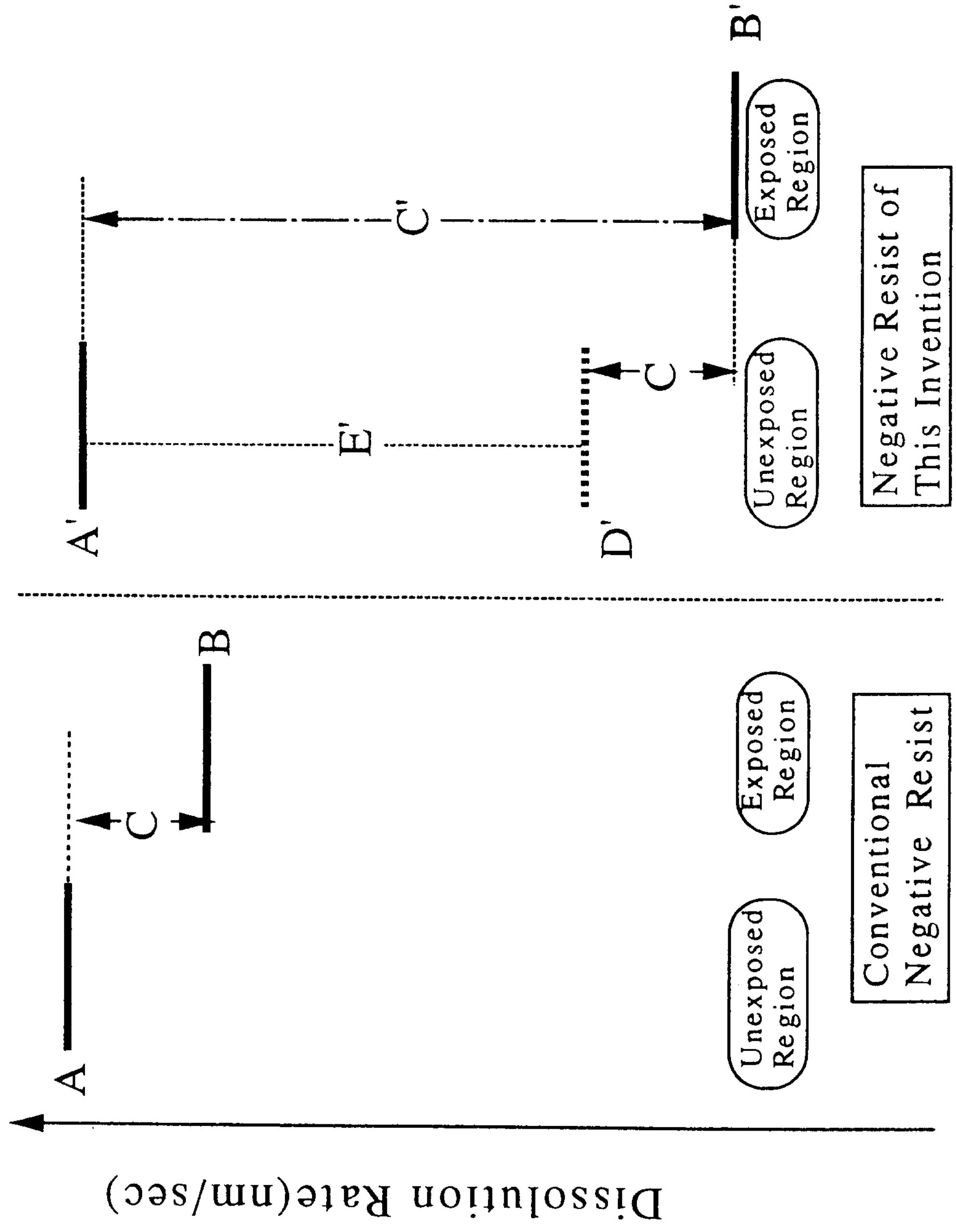
A
B
C
Unexposed Region
Exposed Region
Conventional Negative Resist
A'
B'
C'
C
D'
E'
Unexposed Region
Exposed Region
Negative Resist of This Invention
Dissolution Rate(nm/sec)

FIG. 2

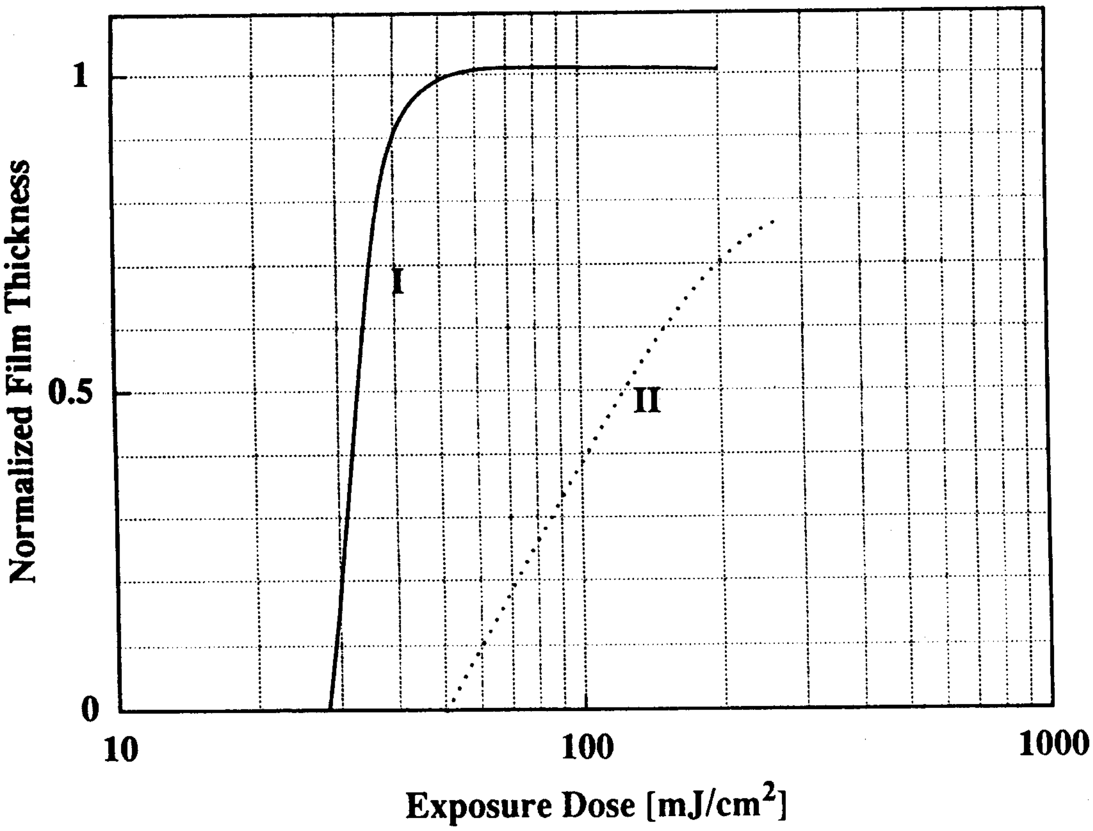
1
0.5
0
Normalized Film Thickness
I
II
10
100
1000
Exposure Dose [mJ/cm2]

FIG. 3

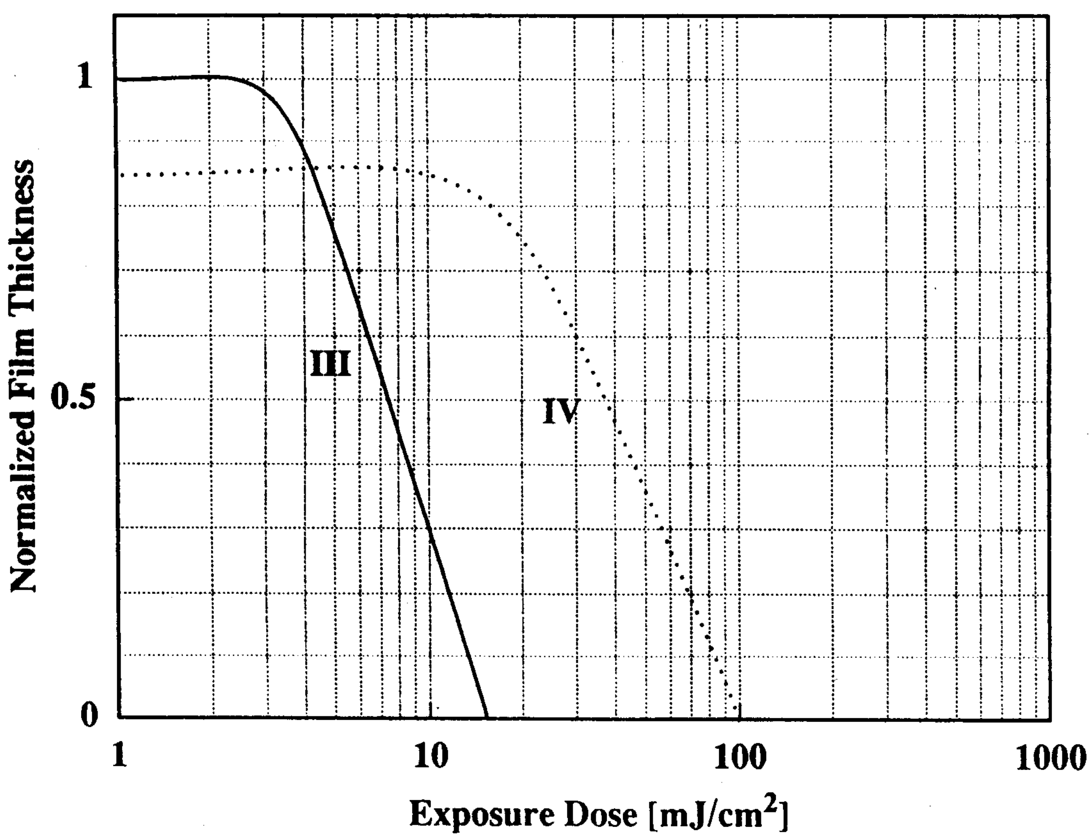
1
0.5
0
Normalized Film Thickness
III
IV
1
10
100
1000
Exposure Dose [mJ/cm2]